# EUROPEAN PATENT APPLICATION

(11) **EP 4 723 388 A1**
(43) Date of publication of application: **08.04.2026**
(21) Application number: 24838839.9
(22) Date of filing: 10.07.2024
(51) Int. Cl.: H01R 13/24

(54) **ELECTRONIC DEVICE**

(30) Priority: 11.07.2023 CN 202310850985
(71) Applicant: Huawei Technologies Co., Ltd., Shenzhen, Guangdong 518129 (CN)
(72) Inventor: LI, Min, Shenzhen, Guangdong 518129 (CN); LI, Dingfang, Shenzhen, Guangdong 518129 (CN); ZHANG, Li, Shenzhen, Guangdong 518129 (CN)
(74) Representative: MERH-IP Matias Erny Reichl Hoffmann Patentanwälte PartG mbB
(86) International application number: PCT/CN2024/104779
(87) International publication number: WO 2025/011587

(57) **Abstract**

This application provides an electronic device. The electronic device includes a chassis, a first board, a second board, a connector assembly, and a peer connector. The connector assembly is installed on the first board, and the peer connector is installed on the second board. The connector assembly includes a fastening frame, a connector, and an elastic member. The fastening frame includes a bottom wall and a side wall. The bottom wall and the side wall are connected to form an accommodating cavity. The connector is installed in the accommodating cavity, and the connector is plugged into the peer connector. The elastic member is disposed between the bottom wall and the connector, and is configured to drive the connector to abut against the peer connector. The first board and the second board are installed in the chassis. The first board includes a first body and a first stop block. The first stop block is disposed on the first body. The chassis includes a first position limiting structure. The first position limiting structure abuts against the first stop block, and the first position limiting structure is configured to limit a position of the first board. When the connector is plugged into the peer connector, there is a small fitting gap between the connector and the peer connector, thereby achieving high efficiency of signal transmission.

## Description

### CROSS-REFERENCE TO RELATED APPLICATIONS

This application claims priority to Chinese Patent Application No. 202310850985.6, filed with the China National Intellectual Property Administration on July 11, 2023 and entitled "ELECTRONIC DEVICE", which is incorporated herein by reference in its entirety.

### TECHNICAL FIELD

This application relates to the field of electronic device technologies, and in particular, to an electronic device.

### BACKGROUND

In a chassis-type communication device, a high-speed signal often needs to be transmitted across circuit boards. For example, in a conventional connection solution, board-to-board transfer needs to be implemented through a backplane. With improvement of a transmission rate, transmission across the circuit boards poses increasingly great impact on a high-speed signal link. Because a path of transmission through the backplane is long, consequently a transmission loss is high and it is difficult to improve a transmission rate of the signal. Therefore, a backplane-free orthogonal architecture emerges. The orthogonal architecture implements direct connection between boards without a need to install the backplane for signal transmission, so that the transmission loss decreases, thereby improving a transmission rate of the device and breaking through a line rate bottleneck of a conventional backplane architecture. In the orthogonal architecture, boards need to be connected to each other through connectors. For example, the connectors include a male connector and a female connector. After the male connector and the female connector are plugged into and fit with each other, a gap between the male connector and the female connector greatly affects quality of the high-speed signal. However, reducing the gap between the male connector and the female connector brings about an additional problem. For example, for a purpose of zero-gap fitting between the male connector and the female connector, mutual collision may occur during board installation, causing a problem of damage to the connectors.

### SUMMARY

This application provides an electronic device. The electronic device has a small connector plugging gap, thereby improving signal transmission efficiency of the electronic device.

This application provides an electronic device. The electronic device includes a chassis, a first board, a second board, a connector assembly, and a peer connector. The connector assembly is installed on the first board, and the peer connector is installed on the second board. The connector assembly is plugged into the peer connector. To reduce a gap to be generated after the connector assembly is plugged into the peer connector, the connector assembly may employ a movable part to connect to the peer connector, thereby reducing the gap. Specifically, the connector assembly includes a fastening frame, a connector, and an elastic member, the fastening frame includes a bottom wall and a side wall, and the bottom wall and the side wall are connected to form an accommodating cavity. The side wall may be tubular, and is connected to the bottom wall to form a sleeve. A hollow portion of the sleeve is the accommodating cavity. The connector is installed in the accommodating cavity, and can slide in the accommodating cavity in a plugging direction. The peer connector is installed on the second board. Because a tolerance is generated in a production process and the tolerance may be generated by the second board or generated during preparation of the peer connector and the second board, the connector may not be tightly plugged into the peer connector due to impact of this tolerance. The elastic member is disposed in the accommodating cavity, and the elastic member is located between the bottom wall and the connector. The elastic member can drive the connector to abut against the peer connector, so that the connector is tightly plugged into the peer connector, thereby overcoming a problem about the gap that is generated after the plugging due to the foregoing tolerance.

The connector is a female connector or a male connector, and may be selected and designed according to a requirement.

The first board and the second board are installed in the chassis. The first board includes a first body and a first stop block. The first stop block is disposed on the first body. The chassis includes a first position limiting structure, and the first position limiting structure is configured to limit a position of the first board. The first position limiting structure is located on a side that is of the first stop block and that faces the second board, and the first position limiting structure abuts against the first stop block, so that a preset distance exists between the first board and the second board, thereby reducing cases in which the fastening frame collides with the peer connector or the first board collides with the second board because the first board is inserted too deeply into the chassis. On a premise of maintaining the preset distance between the first board and the second board, the movable connector slides in the plugging direction and is plugged into the peer connector under an effect of an elastic force of the elastic member according to an actual distance between the first board and the second board, to implement signal transmission between the first board and the second board. The electronic device in this application can reduce cases in which the first board collides with the second board, and there is a small fitting gap between the connector assembly and the peer connector. Therefore, signal transmission efficiency of the electronic device is high.

The first board and the second board may be installed in an orthogonal manner. To be specific, the first board and the second board are installed vertically to each other. For example, the first board is vertically installed in the chassis, and the second board is horizontally installed in the chassis. The electronic device in this application employs an orthogonal architecture, to shorten a cabling distance from the first board to the second board to a maximum extent, thereby improving a signal transmission rate.

To reduce cases in which the connector falls off because the connector stretches out of the fastening frame by a large length, the fastening frame may further include a position limiting member, and the connector is provided with a stopping shoulder, where the stopping shoulder is located between the position limiting member and the bottom wall. When the elastic member drives the connector to slide in the plugging direction, the position limiting member abuts against the stopping shoulder to limit a sliding range of the connector. In addition, when the elastic member applies an elastic force toward the peer connector to the connector, the arrangement of the position limiting member enables the elastic member to have a pre-tension force. When the connector is plugged into the peer connector, the elastic member drives the connector to abut against the peer connector and the pre-tension force reduces a gap between the connector and the peer connector in the plugging direction, thereby improving an effect of connection between the connector and the peer connector.

In a further technical solution, after the first board and the second board are installed in the chassis, the connector assembly and the peer connector may not be at positions right opposite to each other in the plugging direction, resulting in a case in which the connector cannot be plugged into the peer connector. Therefore, a gap is disposed between the connector and the side wall of the fastening frame, so that the elastic member can drive the connector to float in the accommodating cavity, and a floating direction is perpendicular to the plugging direction, thereby helping improve an effect of connection between the connector assembly and the peer connector.

When the gap is specifically provided, a width of the gap is less than or equal to 0.5 millimeter.

The first board includes a first circuit board and the connector is connected to the first circuit board through a cable, to implement signal transmission between the first board and the second board. The cable may be a flexible cable, so that when the connector moves, impact on reliability of connection between the connector and the first circuit board is minor, thereby helping prolong a service life of the electronic device.

The bottom wall has a through hole, and the cable passes through the through hole to connect to the connector.

In a further technical solution, to balance a stress on the connector, the connector assembly may include at least two elastic members, and the at least two elastic members are symmetrically arranged between the connector and the bottom wall.

The electronic device includes at least one first board and at least one second board, the at least one second board is arranged in a first direction, and the at least one first board is arranged in a second direction. The first direction, the second direction, and the plugging direction are perpendicular to each other. Each first board is to be connected in a plugging manner to each second board. For a compact structure of the electronic device, the fastening frame may include at least two accommodating cavities. The at least two accommodating cavities are arranged in the first direction, one connector is disposed in each accommodating cavity, and each connector is configured to connect to the peer connector.

### BRIEF DESCRIPTION OF DRAWINGS

FIG. 1 is a diagram of a structure of an electronic device according to an embodiment of this application;
FIG. 2 is a three-dimensional view of assembly of a second board and a first board according to an embodiment of this application;
FIG. 3 is a diagram of a structure of an electronic device according to another embodiment of this application;
FIG. 4 is a diagram of assembly of a second board and a first board according to an embodiment of this application;
FIG. 5 is a diagram of a structure of a connector assembly according to an embodiment of this application; and
FIG. 6 is a diagram of assembly of a connector assembly and a peer connector according to an embodiment of this application.

Reference numerals:
100: chassis; 10: first board; 20: second board; 1: connector assembly; 2: peer connector; 101: top plate; 102: side plate; 103: bottom plate; X: first direction; Y: second direction; Z: plugging direction; 104: first position limiting structure; 3: fastening frame; 4: connector; 31: bottom wall; 32: side wall; 30: accommodating cavity; 5: elastic member; 33: position limiting member; 41: stopping shoulder; 11: first body; 12: first circuit board; 21: second body; 22: second circuit board; 6: cable; 311: through hole; 13: first stop block; 23: second stop block.

### DESCRIPTION OF EMBODIMENTS

To make the objectives, technical solutions, and advantages of this application clearer, the following further describes this application in detail with reference to the accompanying drawings. However, example implementations may be implemented in a plurality of forms, and should not be construed as being limited to implementations described herein. Identical reference numerals in the accompanying drawings indicate identical or similar structures. Therefore, repeated description thereof is omitted. Expressions of positions and directions in embodiments of this application are described by using the accompanying drawings as an example. However, changes may also be made as desired, and all the changes fall within the protection scope of this application. The accompanying drawings in embodiments of this application are merely used to illustrate relative position relationships and do not represent an actual scale.

It should be noted that details are given in the following descriptions to facilitate understanding of this application. However, this application can be implemented in a plurality of manners different from those described herein, and a person skilled in the art may perform similar promotion without departing from the connotation of this application. Therefore, this application is not limited to the following disclosed specific implementations.

To facilitate understanding of an electronic device provided in embodiments of this application, the following first describes an application scenario of the electronic device. The electronic device in embodiments of this application may be an electronic device such as a communication device (for example, a router), a computing device (for example, a cluster server), a network device (for example, a switch), or a storage device (for example, a storage array). A specific type of the electronic device is not limited in this application, and the technical solutions provided in this application may be used for any electronic device that needs to be connected through a connector.

The technical solutions of this application are particularly applicable to a scenario in which boards match each other in an orthogonal architecture. The orthogonal architecture is short for a backplane-free orthogonal architecture and means, for example, a hardware structure in which a line processing unit (Line Processing Unit, LPU) of a router or an interface board (Interface Board) of a switch is orthogonal to a switch fabric unit (Switch Fabric Unit, SFU) of a switch and the two are directly connected. "Orthogonality" means a vertical relationship between vectors in three-dimensional space. In terms of the hardware architecture, the line processing unit is horizontally inserted and the switch fabric unit is vertically inserted, or the line processing unit is vertically inserted and the switch fabric unit is horizontally inserted.

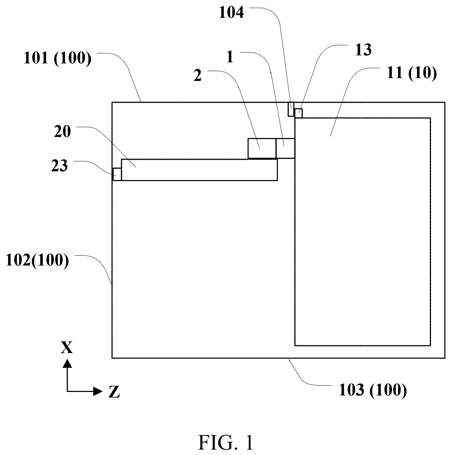

FIG. 1 is a diagram of a structure of an electronic device according to an embodiment of this application. As shown in FIG. 1, the electronic device provided in this application includes a chassis 100, a first board 10, a second board 20, a connector assembly 1, and a peer connector 2. The first board 10 and the second board 20 are assembled in an orthogonal manner. Specifically, the first board 10 and the second board 20 may be perpendicular to each other. In a specific embodiment, the first board 10 may be specifically the switch fabric unit, and the second board 20 may be specifically the line processing unit. Specifically, the chassis 100 may be a square box, or may be a square frame. In the embodiment shown in FIG. 1, an example is used in which the chassis 100 is a square box. As shown in FIG. 1, the chassis 100 includes a top plate 101, side plates 102, and a bottom plate 103 that are connected to each other. The top plate 101 and the bottom plate 103 are parallel to each other. In this embodiment, the second board 20 is horizontally installed in the chassis 100, and is parallel to the top plate 101. The first board 10 is vertically installed in the chassis 100, and is perpendicular to both the bottom plate 103 and the side plates 102. The connector assembly 1 is installed on the first board 10, and the peer connector is installed on the second board 20. The connector assembly 1 is plugged into the peer connector 2, to implement signal transmission between the first board 10 and the second board 20. The electronic device in this application employs an orthogonal architecture, to shorten a cabling distance from the first board 10 to the second board 20 to a maximum extent, thereby improving a signal transmission rate.

Refer to FIG. 1 again. During assembly of the first board 10 and the second board 20, if a distance reserved between the first board 10 and the second board 20 is insufficient, a case may occur in which the first board 10 and the second board 20 or the connector assembly 1 and the peer connector 2 collide with each other. To resolve the foregoing problem, in this embodiment of this application, the first board 10 further includes a first body 11 and a first stop block 13. The chassis 100 includes a first position limiting structure 104. The first position limiting structure 104 is located on a side that is of the first stop block 13 and that faces the second board 20, and the first position limiting structure 104 is configured to limit a position of the first board 10. During assembly, the second board 20 is first installed in the chassis 100, and then the first board 10 is inserted into the chassis 100, so that the first stop block 13 abuts against the first position limiting structure 104, and the second board 20 and the first board 10 are spaced from each other by a preset distance in a plugging direction Z, thereby reducing cases of damage that could be caused when the connector assembly 1 collides with the peer connector 2 because the first board 10 is inserted into the chassis 100 too deeply during installation.

The following describes a position relationship between the first stop block 13 and the first position limiting structure 104 by using an example.

In an embodiment, as shown in FIG. 1, the first position limiting structure 104 may be a bump, the first position limiting structure 104 may be disposed on a side that is of the top plate 101 of the chassis 100 and that faces the inside of the chassis 100, and the first stop block 13 may be disposed on a side that is of the first body 11 and that faces the top plate 101. The first position limiting structure 104 may be specifically located in a middle portion of the top plate 101 in the plugging direction Z, and the first stop block 13 is located at an edge that is of the first body 11 and that faces the top plate 101.

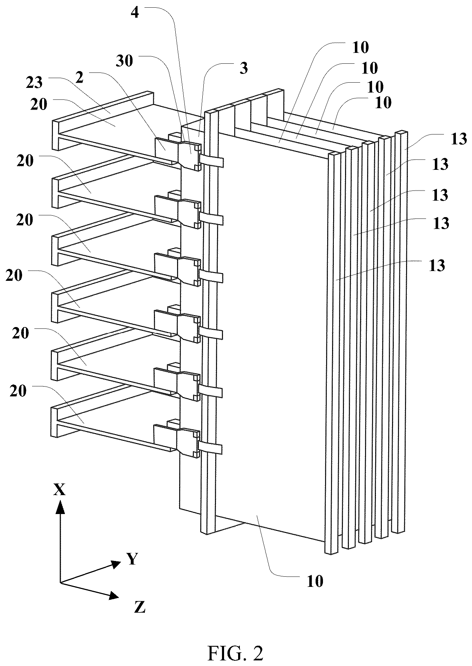

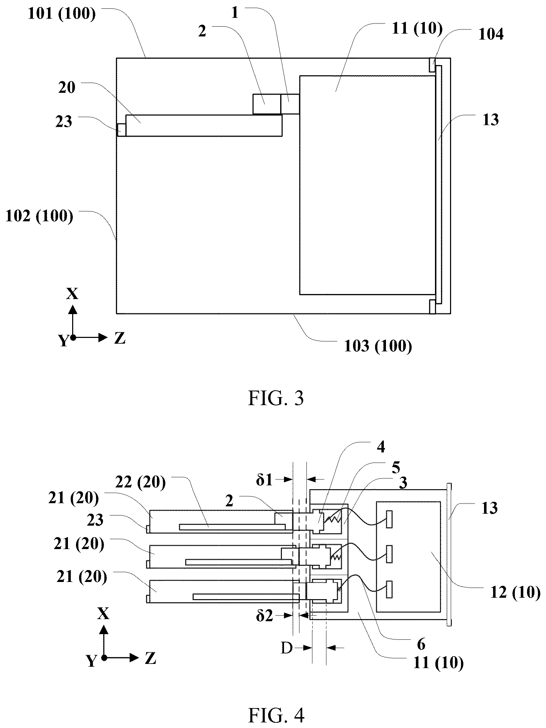

FIG. 2 is a three-dimensional view of assembly of a second board and a first board according to an embodiment of this application. FIG. 3 is a diagram of a structure of an electronic device according to another embodiment of this application. As shown in FIG. 2 and FIG. 3, in another embodiment, the first stop block 13 may be strip-shaped and installed on a side that is of the first body 11 and that is away from the second board 20, and a length of the first stop block 13 is greater than a length of the first body 11 in a first direction X. The first direction X is perpendicular to the top plate 101. At one end that is of the first stop block 13 and that faces the top plate 101 and at one end that is of the first stop block 13 and that faces the bottom plate 103, there are some protrusions relative to the first body 11. There may be two first position limiting structures 104, which are respectively disposed at one end of the top plate 101 and one end of the bottom plate 103 that are away from the side plate 102. In a possible implementation, the side plate 102 is perpendicular to the plugging direction Z. During installation of the first board 10, both an upper end and a lower end of the first stop block 13 can abut against the first position limiting structure 104, to limit the position of the first board 10.

As shown in FIG. 1 or FIG. 3, the second board 20 may include a second body 21 and a second stop block 23. The second stop block 23 is located on a side that is of the second body 21 and that faces the side plate 102, and the second stop block 23 abuts against the side plate 102, to reduce cases in which the second board 20 collides with the chassis 100.

In an optional implementation, the first stop block 13 and the second stop block 23 may be made of a flexible material such as rubber; or a flexible film material is coated on surfaces of the first stop block 13 and the second stop block 23. In this solution, the first stop block 13 can play a buffering function when abutting against the first position limiting structure 104, and similarly the second stop block 23 can play a buffering function when abutting against the side plate 102, thereby protecting the chassis structure and reducing vibration and noise.

As shown in FIG. 2, in an embodiment, the electronic device includes at least one first board 10 and at least one second board 20. The at least one second board 20 is arranged in the first direction X, and the at least one first board 10 is arranged in a second direction Y. The first direction X, the second direction Y, and the plugging direction Z are perpendicular to each other.

FIG. 4 is a diagram of assembly of a second board and a first board according to an embodiment of this application. As shown in FIG. 4, during preparation of the second board 20, there is a structural tolerance between different second boards 20 due to impact of a manufacturing process; or due to impact of an environmental factor, the second boards 20 may be deformed, resulting in inconsistent lengths of the second boards 20 in the plugging direction Z. During installation of the peer connector 2, an installation tolerance may also occur. As a result, a distance between each peer connector 2 installed on the second board 20 and a corresponding connector assembly 1 installed on the first board 10 varies in the plugging direction Z. A total tolerance between different second boards 20 due to the structural tolerance, deformation, and the installation tolerance of the peer connector is δ1.

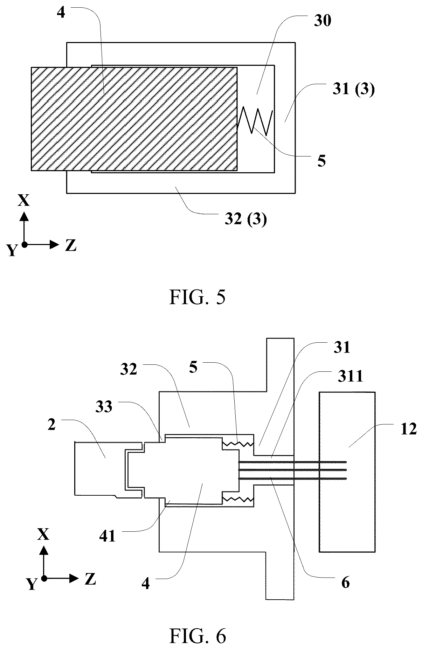

FIG. 5 is a diagram of a structure of a connector assembly according to an embodiment of this application. Due to impact of the total tolerance, the connector assembly 1 and the peer connector 2 cannot be connected to each other or cannot be properly connected to each other in a plugging manner. Therefore, the connector assembly 1 of the electronic device in this application employs a movable connector to connect to the peer connector 2. Specifically, as shown in FIG. 4 and FIG. 5, the connector assembly 1 includes a fastening frame 3, a connector 4, and an elastic member 5. The fastening frame 3 includes a bottom wall 31 and a side wall 32. The bottom wall 31 and the side wall 32 are connected to form an accommodating cavity 30, and the connector 4 is installed in the accommodating cavity 30. In a possible implementation, the bottom wall 31 is perpendicular to the plugging direction Z, the side wall 32 is parallel to the plugging direction Z, and the bottom wall 31 and the side wall 32 are enclosed to form the fastening frame 3 in a shape similar to a sleeve. The connector 4 is installed in the fastening frame 3, and can slide in the plugging direction Z. The elastic member 5 is disposed between the connector 4 and the bottom wall 31. The elastic member 5 is configured to apply an elastic force toward the peer connector 2 to the connector 4, to drive the connector 4 to abut against the peer connector 2. The connector 4 can slide in the plugging direction Z, thereby reducing cases in which the peer connector 2 and the connector assembly 1 of the first board 10 cannot be connected to each other or cannot be properly connected to each other in a plugging manner due to the total tolerance δ1 of the second board 20.

Refer to FIG. 4 again. In an embodiment, a plurality of second boards 20 are aligned in the first direction X by using the second stop blocks 23 at left ends as limiting points, and a plurality of first boards 10 are aligned in the second direction Y by using the first stop blocks 13 at right ends as limiting points, so that positions of the first board 10 and the second board 20 in the chassis 100 are determinate, thereby ensuring that the preset distance is maintained between the first board 10 and the second board 20 to prevent them from colliding with each other. On a premise of maintaining the preset distance between the first board 10 and the second board 20, the movable connector 4 slides in the plugging direction Z and is plugged in a gap-free manner into the peer connector 2 under an effect of an elastic force of the elastic member 5 according to an actual distance between the first board 10 and the second board 20, to implement signal transmission between the first board 10 and the second board 20. The electronic device in this application can reduce cases in which the first board 10 collides with the second board 20, and there is a small fitting gap between the connector assembly 1 and the peer connector 2. Therefore, signal transmission efficiency of the electronic device is high.

In an optional embodiment, the connector 4 may be a female connector or a male connector. This is not limited in this application. Selection and design may be performed according to a connection requirement.

In a specific embodiment, the elastic member 5 may be specifically a spring, where one end of the spring is connected to the connector 4, and the other end is connected to the bottom wall 31. Specifically, the spring is crimped between the connector 4 and the bottom wall 31.

FIG. 6 is a diagram of assembly of a connector assembly and a peer connector according to an embodiment of this application. As shown in FIG. 6, to reduce cases in which the connector 4 stretches out of the fastening frame 3 by an excessively large length, the fastening frame 3 may further include a position limiting member 33. The position limiting member 33 is disposed on the side wall 32, and the connector 4 is provided with a stopping shoulder 41. When the elastic member 5 applies an elastic force to the connector 4 and the connector 4 is located at a preset position, the position limiting member 33 abuts against the stopping shoulder 41. The position limiting member 33 limits a sliding range of the connector 4, to ensure that the connector 4 is limited to a position within the accommodating cavity 30 and does not slide out.

When the connector assembly 1 is specifically disposed, in a natural state, the elastic member 5 is in an energy storage state and applies an elastic force toward the peer connector 2 to the connector 4. The arrangement of the position limiting member 33 enables the elastic member 5 to have a pre-tension force. The connector 4 can be plugged into the peer connector 2 under an effect of the pre-tension force. The natural state means a state in which the connector 4 is not plugged into the peer connector 2. In a specific embodiment, in a plugging process, the connector 4 further needs to overcome frictional resistance from the peer connector 2. In this case, the pre-tension force of the elastic member 5 should be greater than or equal to a friction force of plugging and fitting between the connector 4 and the peer connector 2 multiplied by a safety coefficient, to help improve an effect of gap-free plugging between the connector 4 and the peer connector 2. The safety coefficient means a coefficient used to represent a degree of structural safety in an engineering structure design method. For determining of the safety coefficient, various uncertainties, such as a load, mechanical properties of a material, a difference between a test value, a designed value, and an actual value, a computing mode, and construction quality, need to be considered.

Refer to FIG. 4 again. The first board 10 also has a tolerance due to impact of a manufacturing process and an environment. During installation of the connector assemblies 1, a length of each connector assembly 1 varies in the plugging direction Z. As a result, a distance between each connector assembly 1 installed on the first board 10 and a corresponding peer connector 2 installed on the second board 20 varies in the plugging direction Z. The total tolerance of the first board 10 is δ2 based on a structural tolerance, deformation, and an installation tolerance of the connector assembly 1. As shown in FIG. 4, states of connectors 4 from top to bottom are respectively as follows: A connector 4 is located at a maximum limited position in the fastening frame 3; a connector 4 is located at a middle position of the fastening frame 3 after being plugged into the peer connector 2; and a connector 4 is pressed by the peer connector 2 and is located at a minimum limited position in the fastening frame 3. A maximum distance by which the connector 4 can move in the accommodating cavity 30 is D. In this embodiment of this application, a maximum amount D of movement of the connector 4 in the fastening frame 3 is greater than or equal to δ1 + δ2. In this case, when the first board 10 and the second board 20 are both connected in a state with the maximum total tolerance, an amount of movement of the connector 4 of the connector assembly 1 in the plugging direction Z can absorb all of the tolerances, so that connection can be implemented between the connector 4 and the peer connector 2 in a gap-free plugging manner, and signals can be transmitted at a high speed reliably through the connector assembly 1 and the peer connector 2.

As shown in FIG. 4 and FIG. 6, there is also an installation tolerance when the second board 20 is assembled in the first direction X. For example, distances between two adjacent second boards 20 are unequal, or projections of two adjacent second boards 20 in the first direction X do not coincide, or projections of the peer connectors 2 installed on two adjacent second boards 20 in the first direction X do not coincide. As a result, positions of the peer connector 2 and the connector assembly 1 in the plugging direction Z cannot be fully right opposite to each other. To overcome this problem, a gap may be provided between the connector 4 and the side wall 32, and a gap also exists between the connector 4 and the position limiting member 33 in both the first direction X and the second direction Y, so that the connector 4 can float in the fastening frame 3. In other words, the connector 4 can slide in the plugging direction Z and can also move in the first direction X and the second direction Y.

In a specific embodiment, a width of the gap may be less than or equal to 0.5 millimeter. Therefore, the accommodating cavity 30 and the connector 4 fit in a gap manner, and the elastic member 5 drives the connector 4 to slide in the plugging direction Z, so that the connector 4 floats in the three directions in the accommodating cavity 30, thereby reducing a problem that the connector 4 and the peer connector 2 cannot be connected to each other or cannot be properly connected to each other in a plugging manner due to various tolerances that occur during assembly of the first board 10 and the second board 20.

Refer to FIG. 4 again. In an embodiment, the first board 10 includes a first body 11 and a first circuit board 12, and the first circuit board 12 is fastened to the first body 11. The connector 4 is connected to the first circuit board 12 through a cable 6. As shown in FIG. 6, the bottom wall 31 of the fastening frame 3 faces the first circuit board 12, and a through hole 311 may be provided on the bottom wall 31, where the through hole 311 is configured for the cable 6 to pass through. The cable 6 may be a flexible cable, and its shape changes as the connector 4 moves, so that when the connector 4 moves, impact on reliability of connection between the connector 4 and the first circuit board 12 is minor, thereby helping prolong a service life of the electronic device.

The second board 20 includes a second body 21 and a second circuit board 22. The second circuit board 22 is installed on and fastened to the second body 21, and the peer connector 2 is connected to the second circuit board 22. The peer connector and the connector assembly are connected to each other in a plugging manner to implement connection between the first board and the second board. The electronic device in this application implements signal transmission between the first board 10 and the second board 20 in a plugging manner in which one end is fastened and another end is floating. That one end is fastened means the position of the peer connector 2 is fastened relative to the second board 20, and that another end is floating means the position of the connector 4 is not fastened relative to the first board 10. The floating design of the connector 4 can adapt to a case of mismatch of board assembly positions due to a structure tolerance and an installation tolerance, and there is a small fitting gap between the connector 4 and the peer connector. Therefore, signal transmission efficiency of the electronic device is high.

To balance a stress on the connector 4, the connector assembly 1 may include at least two elastic members 5, and the at least two elastic members 5 are symmetrically arranged between the connector 4 and the bottom wall 31. In a specific implementation, the through hole 311 may be located in a center of the bottom wall 31, and a central axis of the connector 4 may be disposed with an axis of the through hole 311. The elastic members 5 are all disposed on peripheral sides of the through hole 311.

Refer to FIG. 2 again. In an embodiment, a plurality of second boards 20 are arranged in the first direction X, and a plurality of first boards 10 are arranged in the second direction Y. Each second board 20 is provided with a plurality of peer connectors 2, and the plurality of peer connectors 2 are arranged in the second direction Y. Each first board 10 is to be connected in a plugging manner to the plurality of second boards 20. To simplify the device structure and improve assembly efficiency, when the fastening frame 3 is specifically prepared, at least two accommodating cavities 30 may be provided on the fastening frame 3, where the at least two accommodating cavities 30 are arranged in the first direction X, one connector 4 is disposed in each accommodating cavity 30, and each connector 4 is plugged into a corresponding peer connector 2. In other words, one fastening frame 3 is installed for each first board 10, so that one first board 10 can be connected in a plugging manner to the peer connectors 2 of the plurality of second boards 20 to implement signal transmission, thereby improving assembly efficiency.

Terms used in the foregoing embodiments are merely intended to describe specific embodiments, but are not intended to limit this application. The terms "one", "a", "the", "the foregoing", "that", and "this" in singular forms used in the specification and the appended claims of this application are also intended to include expressions such as "one or more", unless otherwise specified in the context clearly.

Reference to "an embodiment" or "a specific embodiment" or the like described in this specification means that one or more embodiments of this application include a specific feature, structure, or characteristic described with reference to the embodiment. The terms "include", "contain", "have", and their variants all mean "include but are not limited to", unless otherwise specifically emphasized in another manner.

## Claims

1. An electronic device, comprising a chassis, a first board, a second board, a connector assembly, and a peer connector, wherein the connector assembly is installed on the first board, and the peer connector is installed on the second board;
the connector assembly comprises a fastening frame, a connector, and an elastic member, the fastening frame comprises a bottom wall and a side wall, the bottom wall and the side wall are connected to form an accommodating cavity, and the connector is installed in the accommodating cavity;
the connector is plugged into the peer connector, and the elastic member is disposed between the bottom wall and the connector and is configured to drive the connector to abut against the peer connector; and
the first board and the second board are installed in the chassis, the first board comprises a first body and a first stop block, the first stop block is disposed on the first body, the chassis comprises a first position limiting structure, the first position limiting structure is located on a side that is of the first stop block and that faces the second board, the first position limiting structure abuts against the first stop block, and the first position limiting structure is configured to limit a position of the first board.

2. The electronic device according to claim 1, wherein the first board and the second board are perpendicular to each other.

3. The electronic device according to claim 1 or 2, wherein the fastening frame further comprises a position limiting member, the connector is provided with a stopping shoulder, the stopping shoulder is located between the position limiting member and the bottom wall, the connector is driven by the elastic member to slide in a plugging direction, and the stopping shoulder abuts against the position limiting member.

4. The electronic device according to any one of claims 1 to 3, wherein there is a gap between the connector and the side wall.

5. The electronic device according to claim 4, wherein a width of the gap is less than or equal to 0.5 millimeter.

6. The electronic device according to any one of claims 1 to 5, wherein the first board comprises a first circuit board, and the connector is connected to the first circuit board through a cable.

7. The electronic device according to claim 6, wherein the bottom wall has a through hole, and the cable passes through the through hole to connect to the connector.

8. The electronic device according to any one of claims 1 to 7, wherein the connector assembly comprises at least two elastic members, and the at least two elastic members are symmetrically arranged between the connector and the bottom wall.

9. The electronic device according to any one of claims 2 to 8, wherein the fastening frame comprises at least two accommodating cavities, the at least two accommodating cavities are arranged in a first direction, one connector is disposed in each accommodating cavity, each connector is configured to connect to the peer connector, and the first direction is perpendicular to the plugging direction.

10. The electronic device according to any one of claims 1 to 9, wherein the connector is a female connector or a male connector.
